Europäisches Patentamt

European Patent Office

Office européen des brevets

(11) Publication number: 0 241 203
A2

# (12) EUROPEAN PATENT APPLICATION

(21) Application number: 87302777.5

(22) Date of filing: 31.03.87

(51) Int. Cl.⁴: G06F 11/20

(30) Priority: 03.04.86 US 847806

(43) Date of publication of application:
14.10.87 Bulletin 87/42

(84) Designated Contracting States:
AT BE CH DE ES FR GB GR IT LI LU NL SE

(71) Applicant: ADVANCED MICRO DEVICES, INC.
901 Thompson Place P.O. Box 3453
Sunnyvale, CA 94088(US)

(72) Inventor: Wong, Thomas S.W.
827 Rock Canyon Circle
San Jose California 95127(US)
Inventor: Szeto, Thomas
2738 Rainfield Drive
San Jose California 95133(US)
Inventor: Su, Yuan Mou
1409 Petal Way
San Jose California 95129(US)

(74) Representative: Sanders, Peter Colin
Christopher et al
BROOKES & MARTIN High Holborn House
52/54 High Holborn
London WC1V 6SE(GB)

(54) Detecting repaired memory devices.

(57) A method for detecting repaired memory de-
vices having both primary memory rows and redun-
dant memory rows including the steps of applying a
sequence of row addresses to the memory device
and detecting whether a primary row has been replaced by a redundant row at one or more of the row
addresses. A repair detection circuit is also dis-
closed which includes a detection comparator coup-
led, in parallel, to the redundant rows of the memory
device, and an enabling comparator responsive to an
enabling signal and operative to enable or disable
the detection comparator. An further method for
memory devices having both redundant rows and
redundant columns includes detecting whether either
a redundant row or a redundant column of memory
cells has been activated by a row or column ad-
dress.

## DETECTING REPAIRED MEMORY DEVICES

This invention relates generally to semiconductor memory devices, and more particularly to semiconductor memory devices having redundant memory cells which can replace defective primary memory cells.

A common architecture for semiconductor memory devices has individual memory cells (each of which can store one or more bits) arranged into a square matrix. Each memory cell can be uniquely addressed by its row and column number. This form of addressing wherein both a row and column address are used to select a memory cell is known as "cross-selection".

As semiconductor memory technology evolves, ever greater numbers of memory cells are produced on a single memory device. As the number of memory cells per device increases, production yields tend to drop·because a single defective memory cell can render the entire device defective. One solution to this problem is to provide spare or "redundant" memory cells so that defective memory cells can be replaced. Quite often, the redundant memory cells are arranged in rows so that an entire row of primary memory cells can be replaced if one or more of the memory cells in that primary row are defective. Alternatively or additionally, redundant columns of memory cells can be used to replace defective primary columns of memory cells. These redundant memory schemes can significantly improve the overall yield on a production run of of memory devices, and thus lower the per unit production cost of memory devices using redundant memory architecture. A redundant memory architecture is described in our copending European Patent Application 87301687.7.

A memory device repaired by a redundant memory scheme is virtually indistinguishable from a "virgin" good memory device which did not need repair. However, some users of memory devices prefer to know whether a particular, functionally good memory device has been repaired. While invasive techniques for detecting repair are possible whereby the memory device is disassembled and inspected, the prior art does not provide a simple non-invasive method or circuit for determining whether a memory device has been repaired.

In the present specification there is described a non-invasive method for determining whether a memory device has been repaired by applying a sequence of row addresses to the memory device, and detecting whether a primary row of memory cells has been replaced by a redundant row of memory cells at one or more of the row addresses. Preferably, the step of detecting whether a primary row has been replaced by redundant row is accomplished by detecting whether a redundant row is activated by a row address. Alternatively or additionally, a sequence of column addresses can be applied to the memory device to detect whether a primary column of memory cells has replaced a redundant column of memory cells.

The repair detection circuit includes a detector coupled, in parallel, to the redundant rows which develops a repair detection signal if any one of the redundant rows becomes activated by a row address, and an enabling circuit coupled to the detector for selectively enabling and disabling the detector. Alternative embodiments of the described system provide a detector coupled to redundant columns of memory cells, or detectors for both redundant rows and redundant columns of memory cells in a memory device.

Advantages of the described system are that memory devices can be quickly tested to determine whether they have been repaired, the method for testing the memory device is non-invasive and therefore non-destructive, the memory device can be site tested by a customer due to the simplicity of the testing methodology, and the row or column or both addresses of a defective memory cell can be determined.

In the accompanying drawings, by way of example only:-

FIGURE 1 is a block diagram of a memory device with repair detection circuitry in accordance with the present invention;

FIGURE 1a is a truth table representative of signals at various locations on the block diagram of Fig. 1;

FIGURE 2 is a schematic for a repair detection circuit in accordance with the present invention; and

FIGURE 3 is a block diagram of an alternative embodiment for a memory device with repair detection circuitry in accordance with the present invention.

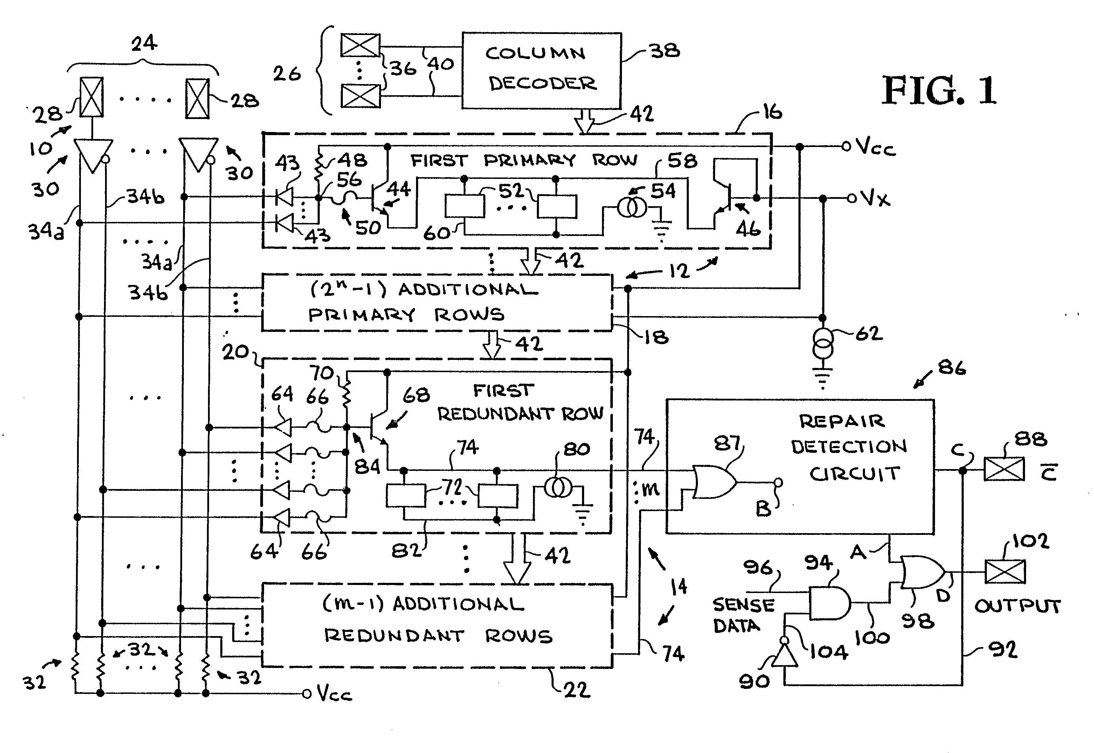

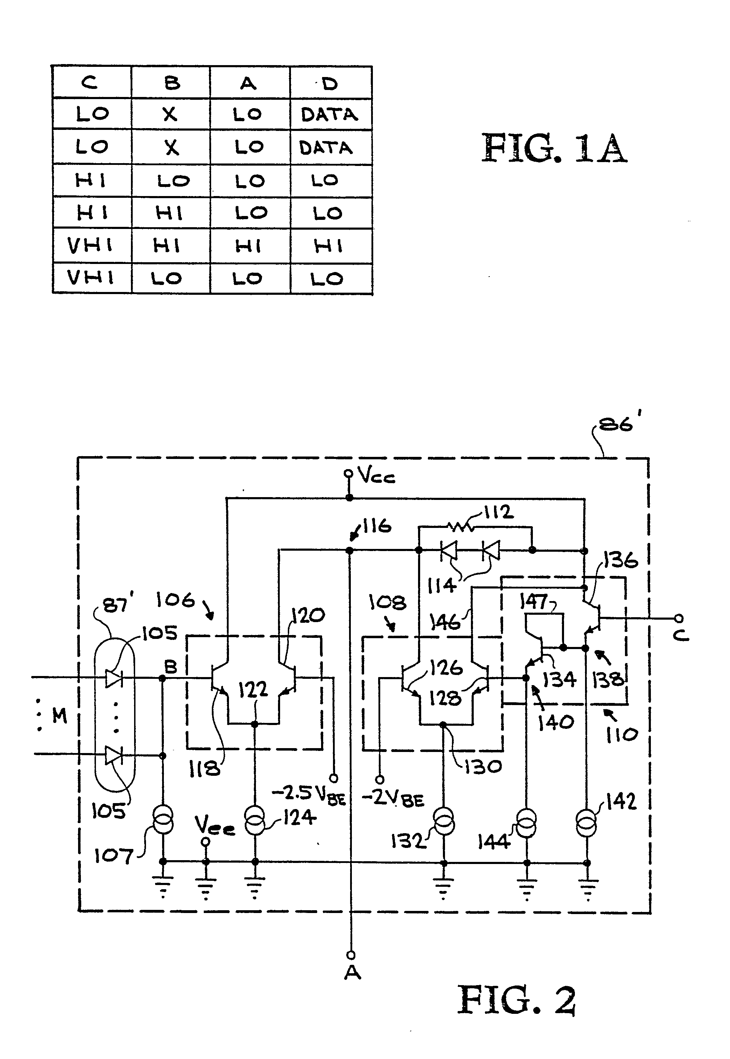

Referring to Fig. 1, a memory device 10 in accordance with the present invention includes a number of primary rows 12 of memory cells and a number of redundant rows 14 of memory cells. Primary rows 12 include a first primary row 16 and a number of additional primary rows 18 which are each substantially identical to primary row 16. Similarly, redundant rows 14 include a first redundant row 20, and a number of additional redundant rows 22 which are each substantially identical to redundant row 20.

Collectively, the memory cells in the primary rows 12 form a primary matrix, and the memory cells in the redundant rows form a redundant matrix. Also it should be understood that the memory can be one or more bits wide. However, for purposes of discussion it will be assumed that the memory described herein is one bit wide except if otherwise noted.

Individual memory cells are addressed by applying a row address to row address lines 24, and a column address to column address lines 26. If there are "n" row address lines 24, then $2^n$ unique row addresses are possible. Similarly, if there are "k" column address lines 26, then $2^k$ unique column addresses are possible. It therefore follows that for n row address lines 24 and k column address lines 26 the total number of unique memory cell addresses is $2^{n+k}$.

Each of the row address lines 24 include an input terminal 28 which is connected to a buffer 30 having a non-inverted output on a line 34a and an inverted output on a line 34b. Resistive elements 32 couple lines 34a and 35b to $V_{cc}$. As will be explained in greater detail subsequently, lines 34a and 34b serve as part of a row address decoder.

Column address lines 26 each include an input terminal 36 which is coupled to a column decoder 38 by a line 40. Column decoder 38 is conventional in design, and produces an output as indicated by arrows 42 which can select a column of memory cells within the primary matrix and the redundant matrix by techniques well known to those skilled in the art.

The first primary row 16 includes n decoding diodes 43, a pair of NPN transistors 44 and 46, a pull-up resistor 48, a fuse 50, 2k memory cells 52, and a constant current source 54. As mentioned previously, the $2^n-1$ additional primary rows indicated by block 18 are each substantially identical to the first primary row 16.

The cathodes of the decoding diodes 43 are coupled to one of lines 34a or 34b of a particular buffer 30. Thus, if there are n row address lines 24, there will also be n decoding diodes 43. Each of the primary rows 12 will have a unique address dependent upon the way the diodes 43 are coupled to the lines 34a and 34b.

The anodes of diodes 43 are coupled together at a node 56. Also coupled to node 56 is fuse 50 and pull-up resistor 48. If any one of diodes 43 is conducting due to its connection to an output line 34a or 34b which is at a logical LO level, node 56 will be pulled down to a logical LO signal level. If none of the diodes 43 are conducting, pull-up resistor 48 will cause node 56 to approach a logical HI level which, in turn, causes the upper word line to attain a logical HI level, activating memory cells 52.

The memory cells 52 are also coupled to a lower word line 60 which is connected to constant current source 54 that provides standby current for the memory cells 52. Transistor 46, which is coupled to a voltage source $V_x$, provides a standby voltage on line 58 which is not sufficient to select the memory cells 52 in the row. Another constant current source 62 is coupled, in parallel, to the base of transistor 46 of row 16 and to the bases of the corresponding transistors in additional primary rows 18.

The number of redundant rows 14 may be given by "m" where, in general, m is a much smaller number than $2^n$. First redundant row 20 includes a number of decoding diodes 64, a number of fuses 66, an NPN transistor 68, a pull-up resistor 70, and a number of memory cells 72. An upper word line 74 is coupled to each of the memory cells 72 in row 20. Memory cells 72 are also coupled, in parallel, to a constant current source 80 by a lower word line 82. The additional m-1 redundant rows 22 are of substantially the same construction as first redundant row 20.

If there are n row address lines 24, there will be 2n decoding diodes 64 and 2n fuses 66. All of the fuses 66 are coupled together at a node 84. The cathodes of decoding diodes 64 are coupled, in pairs, to lines 34a and 34b of one of buffers 30. If any one of diodes 64 is conducting, node 84 will be at a logical LO signal level. In consequence, upper word line 74 will not activate memory cells 72, and the redundant row will be disabled if any one of diodes 64 is conducting. If, however, none of the decoding diodes 64 are conducting, pull-up resistor 70 will raise the voltage at node 84 to a logical HI level, causing upper word line 74 to rise to a logical HI level, activating the memory cells 72 in the redundant row. As mentioned previously, all of the memory cells 72 are coupled, in parallel, by lower word line 82 to a constant current source 80 to provide standby current.

It should be noted that if all of the fuses 66 of a redundant row 20 are intact, that node 84 will always be at a logical LO level and that the memory cells 72 in that row will never be selected. This is because the 2n diodes 64 are coupled to complimentary signals on lines 34a and 34b, and therefore n of the diodes 64 must necessarily be conducting.

If it is determined that one of the primary rows contains a defective memory cell 52, that primary row can be disabled by blowing its fuse 50. Once fuse 50 is blown, transistor 44 can never conduct, and the memory cells 52 in the row 16 can never be activated. There are several methods for blowing fuses in semiconductor memories, including laser methods and voltage overload methods, which will not be discussed here because they are well known to those skilled in the art. Also it should be noted that there are many methods for disabling rows and/or columns other than the fuse method described herein.

If one or more of the primary rows 12 are disabled, it is necessary to substitute redundant rows for them in order to have a fully functional memory device 10. A redundant row such as first redundant row 20 is activated by blowing one of each adjacent pair of fuses 66 such that there will be n intact fuses 66 and n blown fuses 66. The fuses 66 are blown such that the decoding diodes 64 are coupled to the appropriate output lines 34a or 34b of a particular buffer 30 so that the redundant row 20 has the same row address as the primary row that it is replacing.

A repair detection circuit 86 is used to determine whether a redundant row 14 has been substituted for a primary row 12. Repair detection circuit 86 is responsive to the signals on upper word lines 74 of redundant rows 14 and to a control signal developed at a node C, and is operative to develop a detection signal on a line A. As will be discussed in greater detail with respect to Fig. 2, a sensing signal at a node B within detection circuit 86 is the Boolean sum of the signals on upper word lines 74, as is indicated symbolically by an OR gate 87 having m inputs coupled to the m upper word lines 74 of redundant rows 14.

The operation of repair detection circuit 86 is summarized in the truth table shown in Fig. 1a. When the control signal at node C is a logical LO or HI, the detection signal on line A is always a logical LO regardless of the logic level of the sensing signal at node B. When the control signal at node C is a third logical level, VHI, the detection signal on line A is LO if the sensing signal at node B is LO, and the detection signal on line A is HI if the sensing signal at node B is HI. Thus, in operation, repair circuit 86 is enabled or disabled by the control signal at node C, and has an output on line A which is directly related to the signal level at node B when the repair detection circuit is enabled.

Node C is coupled to the CS input terminal 88 and to an inverter 90 by a line 92. The output of the inverter is connected to a first input of a dual-input AND gate 94. The second input of AND gate 94 is connected to a data line 96 having an output data signal which is derived, in a conventional manner, from memory cells 52 and 72 of the memory device 10.

Line A is coupled to a first input of a dual-input OR gate 98, and a second input of OR gate 98 is coupled to the output of AND gate 94 by a line 100. The output of OR gate 98 is coupled to a data output terminal 102 by a line D.

Referring now to both Figs. 1 and 1a, a logical LO at CS input terminal 88 develops a logical HI on an input 104 of AND gate 94. This permits whatever data output signals that are applied to data output line 96 to pass through to line 100 and then into OR gate 98. Since the output on line A is always LO when node C is LO, the output of OR gate 98 is essentially the same signal as the data signal on line 96. In other words, when CS is LO, the repair detection circuit 98 is disabled and data from the memory cells 52 and 72 can be developed on data output terminal 102.

When the input on CS input terminal is at a third logical level VHI (where VHI is at a higher potential then HI), the repair detection circuit is enabled, and the data on line 96 is blocked by AND gate 94 due to the logical LO on line 104 developed by inverter 90. The logic level on line 100 is therefore also LO, and the output on line D will reflect the input on line A. Thus, the chip select CS input can be used to multiplex either data or test results to output terminal 102.

For normal operation of memory device 10, the CS input on input terminal 88 is LO, and row and column addresses are applied to row address lines 24 and column address lines 26, respectively. If the memory device 10 is in a read mode, data corresponding to the contents of memory cells 52 and 72 can be developed on data output terminal 102.

The method for testing the memory device 10 in accordance with the present invention includes applying a VHI logic signal to the CS input terminal 88 to enable the repair detection circuit and to block the data signals on line 96, and then sequentially applying addresses to row address lines 24. If one of the redundant rows 14 is activated by a particular address on row address lines 24, the node B will attain a HI logic level, and a HI logic level will be developed on data output terminal 102. If an address applied to row address lines 24 does not activate a redundant row 14, the logic level on data output terminal 102 will remain LO.

In consequence, the memory device 10 with repair detection circuit 86 permits virgin good memory devices to be distinguished from repaired good memory devices. Furthermore, the exact address of the defective primary row can be determined, since a HI logic level will only be developed at data terminal 102 when a redundant row having the same address as a bad primary row is activated. It is therefore possible to quantitatively determine the extent of the repair to a memory device, and to develop a knowledge of the physical location of the damaged memory cells.

Fig. 2 illustrates a repair detection circuit 86' in accordance with the present invention. The circuit 86' is designed for use in emitter coupled logic (ECL) semiconductor memory devices. As such, the V$_{cc}$ is typically approximately zero volts and logic ground and most other logic levels are negative with respect to V$_{cc}$. The voltage swing between HI and LO logic levels in ECL is quite small, and is typically in the order of .9 volts. In the present ECL design, VHI is approximately +.4V, HI is approximately -.9V, and LO is approximately -1.8V.

The repair detection circuits 86′ includes an OR circuit 87′ comprised of a plurality of diodes 105, a detection comparator 106, an enabling comparator 108, and a voltage reduction circuit 110. A pull-up resistor 112 and a pair of clamping diodes 114 couple V$_{cc}$ to a node 116 of output line A. The anodes of diodes 105 are coupled to the upper word lines 74 of redundant rows 14, and the cathodes of diodes 105 are coupled together at node B. A constant current source 107 couples node B to a V$_{ee}$ power supply of approximately -5 volts, where V$_{cc}$ is logic ground for this circuit.

Detection comparator 106 includes a pair of NPN transistors 118 and 120 coupled together in a common emitter configuration at a node 122. Node 122 is coupled to V$_{ee}$ by a constant current source 124. The base of transistor 118 is coupled to node B, and the base of transistor 120 is coupled to a first reference voltage of -2.5V$_{be}$ (approximately -2 volts). The collector of transistor 118 is coupled to V$_{cc}$, and a collector of transistor 120 is coupled to node 116.

Enabling comparator 108 includes a first NPN transistor 126 and a second NPN transistor 128. The emitters of transistors 126 and 128 are coupled together at a node 130 in a common emitter configuration. Node 130 is coupled to V$_{ee}$ power supply by a constant current source 132. The base of transistor 126 is coupled to a second reference voltage -2V$_{be}$ (approximately -1.6 volts). The collector of transistor 126 is coupled to node 116.

Voltage reduction circuit 110 includes a pair of NPN transistors 134 and 136. The base of transistor 134 is coupled to a node 138, as is the emitter of transistor 136. Thus, transistors 134 and 136 are coupled together in an emitter follower configuration. The base of transistor 128 is coupled to a node 140, as is the emitter of transistor 134 and, therefore, transistors 128 and 134 are also coupled together in emitter follower configuration. Node 138 is coupled to the V$_{ee}$ power supply by a constant current source 142, and node 140 is coupled to the V$_{ee}$ power supply by a constant current source 144. The collectors of transistors 128 and 136 are coupled together and to V$_{cc}$ by a line 146, and the collector and base of transistor 134 are coupled together by a line 147 such that transistor 134 operates as a diode.

The voltage level for a chip select in ECL logic is approximately -2V$_{be}$. When a chip select voltage of -2V$_{be}$ is applied to CS input terminal 88, node C is also at approximately -2V$_{be}$. Since there is a voltage drop of V$_{be}$ through both transistors 136 and 134, the voltage at node 40 during a chip select is approximately -4V$_{be}$. Since the base of transistor 126 is coupled to a second reference voltage of -2V$_{be}$, the base of transistor 126 is at a higher voltage than the base of transistor 128 during a chip select. This causes current source 132 to draw all of its current through transistor 126, shutting off transistor 128. With transistor 126 turned on, node 116 and therefore output line A will be clamped at a LO logic level.

When the logic level on chip select input terminal 88 is raised to +1V$_{be}$, the voltage drops across transistors 136 and 134 bring node 140 to approximately -1V$_{be}$. In this case, the base voltage of transistor 128 is higher than the second reference voltage on the base on transistor 126, and current source 132 draws its current through transistor 128, shutting off transistor 126. Since transistor 126 is shut off, it can no longer pull the voltage down on node 116. The effect of applying a voltage level +1V$_{be}$ or greater to node C, therefore, is to enable detection comparator 106. Of course, whether detection comparator 106 is enabled by a HI voltage level on node C or whether it is disabled by a LO voltage level on node C is purely a matter of semantics.

As mentioned previously, if the voltage level on node C is 1V$_{be}$ or greater, transistor 126 will be shut off and the voltage level at node 116 will be controlled by detection comparator 106. If the voltage level at node B is greater than -2.5V$_{be}$, constant current source 124 will draw all of its current through transistor 118, effectively shutting off transistor 120. Since transistors 120 and 126 are both non-conducting, no current flows through pull-up resistor 112 and node 116 approaches V$_{cc}$. Thus, a voltage on node B which is greater than -2.5V$_{be}$ produces a HI level output on line A. Conversely, a voltage level at node B which is less than -2.5V$_{be}$ produces a LO level output on line A. Therefore, for the repair detection circuit 86′, a HI logic level at node B is a voltage greater than -2.5V$_{be}$, and a LO logic level at node B is a voltage less than -2.5V$_{be}$. A HI logic level output for line A is approximately V$_{cc}$, and a LO logic level for line A is approximately 2 V$_{be}$ lower than V$_{cc}$.

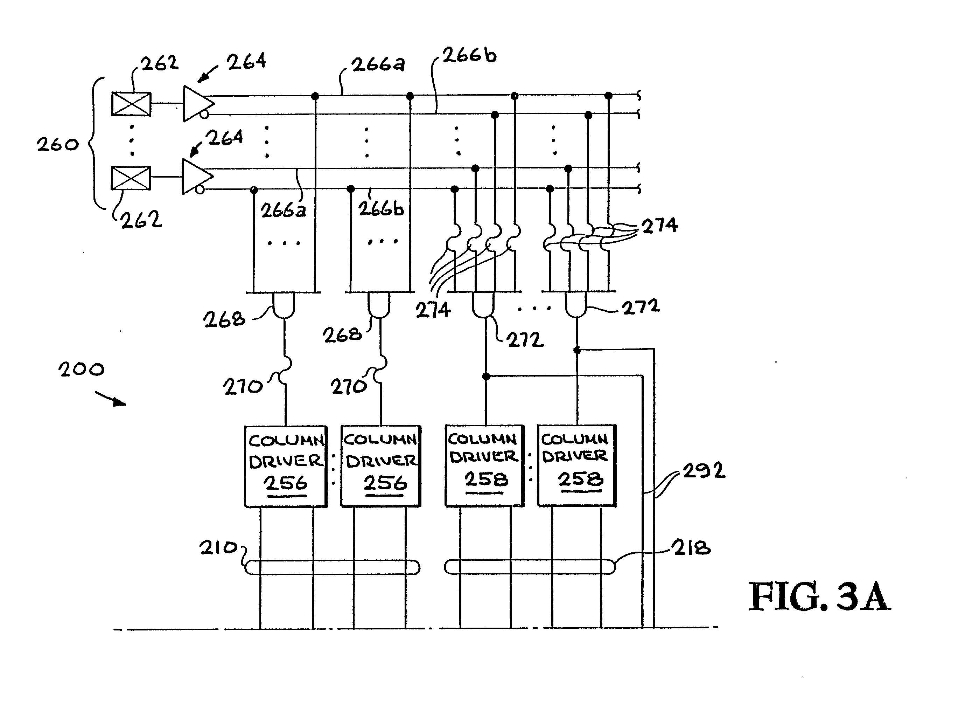

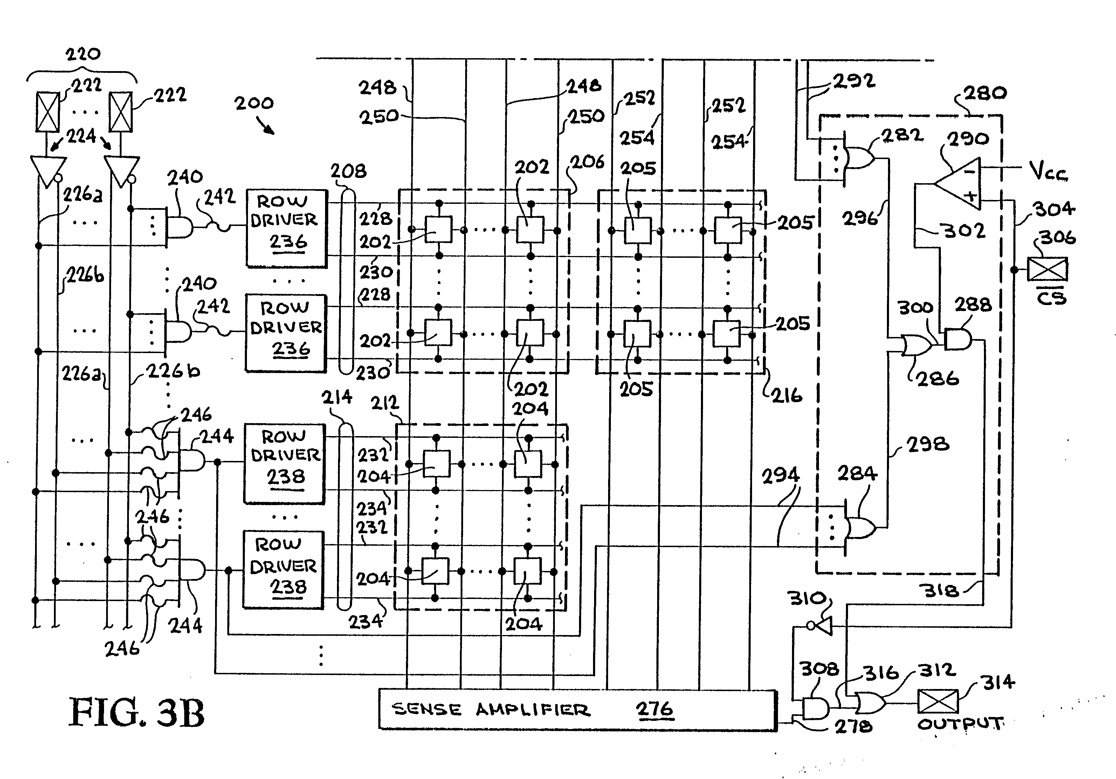

Referring to Fig. 3, an alternate embodiment for a memory device 200 in accordance with the present invention includes a number of primary memory cells 202, a number of redundant row memory cells 204, and a number of redundant column memory cells 205. The primary memory cells 202 are formed into a primary matrix 206 having rows 208 and columns 210. Similarly, redundant row memory cells 204 are formed into a redundant row matrix 212 having rows 214 and columns 210, and redundant column memory cells 205 are formed into a redundant column matrix 216 having rows 208 and columns 218.

Rows 208 and 214 can be addressed via row address lines 220. As before, it will be assumed that there are "n" row address lines 220 to permit $2^n$ unique row addresses. Each row address line 220 has an input terminal 222 which is coupled to an input buffer 224. The input buffers 224 each develop a non-inverted output on a line 226a and an inverted output on a line 226b.

Rows 208 comprise the primary rows for device 200, and rows 214 comprise the secondary rows for device 200. Each of the primary rows 208 include an upper word line 228 and a lower word line 230. Similarly, each of the redundant rows 214 include an upper word line 232 and a lower word line 234. Each word line pair 228/230 is coupled to a row driver 236. Similarly, each word line pair 232/234 is coupled to a row driver 238.

Associated with each row driver 236 is an n input AND gate 240 and a fuse 242. The inputs of AND gates 240 are coupled to lines 226a and 226b of row address lines 220 in such a manner that they produce a unique row address. Associated with each row driver 238 there is a 2n input AND gate 244. Each of the 2n inputs of AND gates 244 is coupled to a line 226a or 226b by a fuse 246.

To deactivate one of the primary rows 208, a fuse 242 is blown to permanently deactivate a row driver 236. One of the redundant rows 214 can then be substituted for the disabled primary row 208 by blowing appropriate fuses 246 such that the redundant row 214 has the same address as the disabled primary row 208.

Each of columns 210 include a left bit line 248 and a right bit line 250. Similarly, each of columns 218 include a left bit line 252 and a right bit line 254. Each of columns 210 is coupled to a column driver 256, and each of columns 218 is coupled to a column driver 258.

The column drivers 256 and 258 can be addressed by column address lines 260, each of which is associated with an input terminal 262. The input terminals 262 are coupled to input buffers 264 which develop a non-inverted output on a line 266a, and an inverted output on a line 266b.

Column drivers 256 are coupled to lines 266a and 266b of column address lines 260 by k input AND gates 268 and fuses 270. The inputs of AND gates 268 are coupled to appropriate lines 266a and 266b such that each of columns 210 has a unique address. Each of column drivers 258 is coupled to lines 266a and 266b of column address lines 260 by a 2k input AND gate 272 and 2k fuses 274. Each of fuses 274 is coupled to a unique one of lines 266a or 266b.

To remove a defective column 210, the fuse 270 associated with the defective column is blown. This permanently disables the associated column drivers 256. A redundant column 218 can then be substituted by blowing the appropriate fuses 274 such that the redundant row 218 has the same column address as the disabled primary column 210.

When a row address is applied to row address lines 220 and a column address is applied to column address lines 260, one of memory cells 202, 204, or 205 is activated. If a memory cell 202 or 204 is activated, a differential signal is developed between bit lines 248 and 250. Similarly, if a memory cell 205 is activated, a differential signal is developed between bit lines 252 and 254. All of the bit lines 248, 250, 252, and 254 are inputs to a sense amplifier 276 which develops a data output on line 278.

A repair detection circuit 280 for device 200 includes three OR gates 282, 284, and 286, an AND gate 288, and a comparator 290. Assuming that there are m redundant rows 214 and m redundant columns 218, the OR gates 282 and 284 have m inputs. The remaining gates of repair detection circuit 280 are dual input devices. The m inputs 292 to OR gate 282 are coupled, one each, to the outputs of AND gates 272. The m inputs 294 of OR gate 284 are coupled, one each, to the outputs of AND gates 244. If any one of the outputs of AND gates 272 is HI, the output of OR gate 282 on a line 296 will also be HI. If the outputs of any one of the AND gates 244 is HI, the output of OR gate 284 on a line 298 will also be HI.

The output of OR gate 286 on a line 300 is one input to AND gate 288, the other being the output of comparator 290 on a line 302. The "+" input to comparator 290 is coupled to a line 304 which is connected to the CS input terminal 306, and the "-" input to comparator 290 is coupled to the $V_{cc}$.

Memory device 200 also includes an AND gate 308, an inverter 310, an OR gate 312, and an output terminal 314. One input of AND gate 308 is the output data line 278 of sense amplifier 276, and the other input of AND gate 308 is coupled to CS line 304 by inverter 310. The output of AND gate 308 on a line 316 is input into OR gate 312, as is the output of AND gate 288 on a line 318. The output of OR gate 312 is coupled to output terminal 314.

Memory device 200 operates on three logic levels, namely LO, HI, and VHI. In the ECL implementation of this circuit, $V_{cc}$ is approximately 0 volts, LO is approximately -1.8v, HI is approximately -.9v, and VHI is approximately +.4v.

When a LO input level is applied to CS input terminal 306, the output of comparator 290 on line 302 will also be LO, as will be the output of AND gate 288 on line 318. Thus, a LO input on CS input terminal 306 disables repair detection circuit 280. The LO input on line 304 is inverted by inverter 310, and the data output on line 278 passes through AND gate 308 and OR gate 312 to the output terminal 314.

When a HI level signal is applied to CS input terminal 306, the output of comparator 290 on line 302 is also LO because HI level signal is still at a lower potential than is $V_{cc}$. Therefore, a HI level signal on CS input terminal 306 also disables comparator 290 and produces a LO level output on line 318. However, inverter 310 inverts the HI level signal on line 304 producing a LO level input to AND gate 308 which prevents the data output on line 278 from passing through AND gate 308 and thus to output terminal 314.

When a VHI signal is applied to CS input terminal 306, comparator 290 will develop a HI level signal on line 302 because the VHI signal is at a higher potential than $V_{cc}$. Thus, a VHI signal on CS input terminal 306 enables the repair detection circuit 280. Concurrently, a LO signal is input to AND gate 308 via the inverter 310, preventing the data output on line 278 from passing through AND gate 308.

Once the repair detection circuit 280 is activated by a VHI level signal on CS input terminal 306, row addresses are sequentially applied to row address lines 220 and column address lines 260, respectively. If any one of the redundant rows 214 is activated by a row address, or if any one of the redundant columns 218 is activated by a column address, a HI level signal will be developed on lines 298 or 296, respectively, developing a HI level output on line 300. When the signal levels on both lines 300 and 302 are HI, a HI level output is developed on line 318 and on output terminal 314 via OR gate 312. Thus, when repair detection circuit 280 is enabled by a VHI signal level on CS input terminal 306, a HI level output will be developed on output terminal 314 when either a redundant row 214 or a redundant column 218 is addressed.

It should be noted that the exact row and column address of a defective primary memory cell 202 can be determined by applying a VHI signal to the CS input terminal 306, and then sequentially applying row address to row address lines 220 and column addresses to column address line 260.

The foregoing description of the preferred embodiment of the present invention has been presented for purposes of illustration and description. It is not intended to be exhaustive or to limit the invention to the precise form disclosed. Obviously, many modifications and variations will be apparent to practitioners skilled in this art. It is possible that the invention may be practiced in other fabrication technologies in MOS or bipolar processes. Similarly, any process steps described might be interchangeably with other steps in order to achieve the same result. The embodiment was chosen and described in order to best explain the principles of the invention and its practical application, thereby enabling others skilled in the art to understand the invention for various embodiments and with various modifications as are suited to the particular use contemplated. It is intended that the scope of the invention be defined by the claims appended hereto and their equivalents.

## Claims

1. A method for detecting repaired memory devices of the type including a plurality of primary memory cells and a plurality of redundant memory cells, where said primary memory cells and said redundant memory cells may be individually addressed, and where a damaged primary memory cell may be replaced by an operational redundant memory cell, said method comprising:
applying a sequence of addresses to a memory device; and
detecting whether a primary memory cell has been replaced by a redundant memory cell.

2. A method as recited in claim 1 wherein detecting whether a primary memory cell has been replaced by a redundant memory cell includes detecting whether a redundant memory cell is activated by at least one address of said sequence of addresses.

3. A method as recited in claim 2 further comprising the step of disabling data outputs of said memory cells prior to applying said sequence of addresses to said memory device.

4. A method as recited in claim 1 wherein at least some of said redundant memory cells are arranged into redundant rows, and wherein applying said sequence of addresses to said memory device comprises applying a sequence of row addresses to said memory device.

5. A method as recited in claim 4 wherein at least some of said redundant memory cells are arranged into redundant columns, and wherein applying said sequence of addresses to said memory device comprises applying a sequence of column addresses to said memory device.

6. A method as recited in claim 1 wherein at least some of said redundant memory cells are arranged into redundant columns, and wherein applying said sequence of addresses to said memory device comprises applying a sequence of column addresses to said memory device.

7. A method for detecting repaired memory devices of the type including a first plurality of primary rows of memory cells and a second plurality of redundant rows of memory cells, where a damaged primary row may be replaced by a redundant row, said method comprising:
applying a sequence of row addresses to a memory device; and
detecting whether a primary row has been replaced by a redundant row at one or more of said row addresses.

8. A method as recited in claim 7 wherein detecting whether a primary row has been replaced by a redundant row includes detecting whether a redundant row is activated by a row address.

9. A method as recited in claim 8 further comprising disabling data outputs of said memory cells prior to applying said sequence of row addresses to said memory device.

10. A method for detecting repaired memory devices of the type including a first plurality of primary columns of memory cells and a second plurality of redundant columns of memory cells; where a damaged primary column may be replaced by a redundant column, said method comprising:
applying a sequence of column addresses to a memory device; and
detecting whether a primary column has been replaced by a redundant column at one or more of said column addresses.

11. A method as recited in claim 10 wherein detecting whether a primary column has been replaced by a redundant column includes detecting whether a redundant column is activated by a column address.

12. A method as recited in claim 11 further comprising disabling data outputs of said memory cells prior to applying said sequence of column addresses to said memory device.

13. A memory device comprising:
a plurality of primary memory cells arranged into a primary matrix having primary rows and primary columns;
a plurality of redundant memory cells arranged into at least one a redundant matrix having redundant rows and redundant columns;
addressing means adapted to provide row and column address signals to said primary matrix and said redundant matrix;
repair means which, when activated, can disable at least one linear arrangement of primary memory cells and enable at least one linear arrangement of redundant memory cells as a replacement for said disabled linear arrangement of primary cells; and
repair detection means for detecting whether said repair means has been activated.

14. A memory device as recited in claim 13 wherein said linear arrangement of primary memory cells and said linear arrangement of redundant memory cells can comprise a row of primary memory cells and a row of redundant memory cells, respectively.

15. A memory device as recited in claim 14 wherein said linear arrangement of primary memory cells and said linear arrangement of redundant memory cells can further comprise a column of primary memory cells and a column of redundant memory cells, respectively.

16. A memory device as recited in claim 13 wherein said linear arrangement of primary memory cells and said linear arrangement of redundant memory cells can comprise a column of primary memory cells and a column of redundant memory cells, respectively.

17. A memory device as recited in claim 13 wherein said repair detection means is coupled to said redundant matrix and is operative to develop a repair detection signal when at least one of said redundant rows and said redundant columns has been enabled.

18. A memory device as recited in claim 17 wherein said repair detection means is responsive to an enabling signal such that said repair detection signal can only be developed when said enabling signal is applied to said repair detection means.

19. A memory device as recited in claim 18 further comprising output gating means responsive to a data signal developed by said memory cells, said repair detection signal, and said enabling signal, and operative to develop an output signal reflective of said data signal when said enabling signal is not present, and further operative to develop an output signal reflective of said repair detection signal when said enabling signal is present.

20. A repair detection circuit for a memory device having a plurality of primary rows of memory cells and at least one redundant row of memory cells, said repair detection circuit comprising:
detection means coupled to said redundant row and operative to develop a repair detection signal if said redundant row becomes activated; and
enabling means coupled to said detection means for selectively enabling said detection means.

21. A repair detection circuit as recited in claim 20 wherein said memory device has a plurality of redundant rows, and wherein said detection means is responsive to each of said plurality of redundant rows such that said repair detection signal is developed if any one of said redundant rows becomes activated.

22. A repair detection circuit as recited in claim 21 wherein said detection means includes a detection comparator responsive to a first reference potential and to a potential developed collectively by said redundant rows, and operative to develop said repair detection signal when said potential developed by said redundant rows has a predetermined relationship to said first reference potential.

23. A repair detection circuit as recited in claim 22 wherein said enabling means includes an enabling comparator responsive to a second reference potential and to an enabling potential, and operative to enable said detection comparator when said enabling potential has a predetermined relationship to said second reference potential.

24. A detection circuit comprising:
sensing means responsive to a plurality of sensing inputs and operative to develop an sensing signal;
detection means responsive to a first reference voltage and to said sensing signal, said detection means being operative to develop a detection signal at a detection node;
enabling means responsive to a second reference voltage and an enabling input and having an enabling node which is coupled to said detection node; and
a voltage source coupled to said detection node and said enabling node.

25. A detection circuit as recited in claim 24 wherein said detection means includes a pair of transistors coupled together in a common emitter configuration, where said first reference voltage is applied to the base of a first transistor, said detection input is coupled to the base of a second transistor, and said detection node is coupled to the collector of said first transistor.

26. A detection circuit as recited in claim 25 wherein said detection means further includes a constant current source coupled to the emitters of said pair of transistors.

27. A detection circuit as recited in claim 24 wherein said enabling means includes a pair of transistors coupled together in a common emitter configuration, where said second reference voltage is applied to the base of a first transistor, said enabling input is coupled to the base of a second transistor, and said enabling node is coupled to the collector of said first transistor.

28. A detection circuit as recited in claim 27 wherein said enabling means further includes a first constant current source coupled to the emitters of said pair of transistors.

29. A detection circuit as recited in claim 28 wherein said enabling means further includes voltage reduction means which couples said enabling input to the base of said second transistor.

30. A detection circuit as recited in claim 24 wherein said voltage source is coupled to said detection node and said enabling node by current limiting means.

31. A detection circuit as recited in claim 30 wherein said voltage source is further coupled to said detection node and said enabling node by voltage reduction means.

32. A detection circuit comprising:
sensing means responsive to a plurality of sensing input signals and operative to develop a sensing output signal; and
output means responsive to said sensing output signal and an enabling signal, and operative to develop a detection signal.

33. A detection circuit as recited in claim 32 further comprising comparator means responsive to a comparator input signal and a reference signal, and operative to develop said enabling signal.

34. A detection circuit as recited in claim 33 wherein said sensing means includes OR gate means having a plurality of inputs responsive to said sensing input signals and an output which develops said sensing output signal.

35. A detection circuit as recited in claim 34 wherein said output means includes AND gate means having a first input responsive to said enabling signal and having a second input responsive to said sensing output signal, said AND gate means having an output which develops said detection signal.

FIG. 1

0 241 203

0 241 203

| C | B | A | D |
|------|------|------|------|
| LO | X | LO | DATA |
| LO | X | LO | DATA |
| HI | LO | LO | LO |
| HI | HI | LO | LO |
| VHI | HI | HI | HI |
| VHI | LO | LO | LO |

# FIG. 1A

# FIG. 2

FIG. 3A

FIG. 3B

0 241 203